# EUROPEAN PATENT APPLICATION

(11) **EP 2 426 487 A1**
(43) Date of publication of application: **07.03.2012**
(21) Application number: 10175283.0
(22) Date of filing: 03.09.2010
(51) Int. Cl.: G01N 27/414, G01N 33/543

(54) **Nano-carbon sensor and method of making a sensor**

(71) Applicant: The Provost Fellows And Scholars Of The College Of The Holy and Undivided Trinity Of Queen Elizabeth Near Dublin, Dublin 2 (IE)
(72) Inventor: Duesberg, Georg, D4 Dublin (IE); Hegner, Martin, D14 Dublin (IE)
(74) Representative: Lucey, Michael

(57) **Abstract**

The invention relates to a sensor device comprising a first layer of graphene providing an interface; and a second layer of at least one bio-compatible component, wherein the first layer is functionalised by anchoring of the at least one bio-compatible component of the second layer to the first layer.

## Description

### Field of the Invention

The invention relates to the use of carbon nano-structures as sensor devices. More particularly, the invention relates to the use of graphene layers in a sensor device.

### Background to the Invention

Nano-carbon structures (NCs) and in particular graphene, exhibit unique mechanical and electrical properties. Many studies have been performed examining the use of carbon-nano tube (CNT) networks as (flexible). The interest in the field has lead to the establishment of many research groups and indeed start-up companies in the last few years.

Previously it was known that carbon nanotubes (CNTs) (Chen, R. J.; Choi, H. C.; Bangsaruntip, S.; Yenilmez, E.; Tang, X. W.; Wang, Q.; Chang, Y. L.; Dai, H. J. J. Am. Chem. Soc. 2004, 126, (5), 1563-1568) and nanowires (NWs) (Zheng, G. F.; Patolsky, F.; Cui, Y.; Wang, W. U.; Lieber, C. M. Nature Biotechnology 2005, 23, 1294-1301) had shown potential as sensor devices. However, CNTs and NWs have poor device reproducibility and suffer from difficulties when brought to large-scale integrated processing.

Now graphene has shown potential in the field of sensor devices (Markus Danerkl, Moritz V. Hauf, Andreas Lippert, Lucas H. Hess, Stefan Birner, Ian D. Sharp, Ather Mahmood, Pierre Mallet, Jean-Yves Veuillen, Martin Stutzmann, and Jose A. Garrido Adv. Funct. Mater. 2010, XX, 108). The basic detection mechanism is that the conduction through a nano-channel is altered due to the adsorption of molecules. These cause "vicinity" doping of the channel, resulting in an enhancement or depletion of the carrier concentration. In a three terminal (transistor) configuration this also can lead to a change from p- to n-doping resulting in opposing transfer characteristics and good sensitivity characteristics. The good sensitivity characteristics stem from the large surface area of graphene or single-walled carbon nanotubes (SWCNTs) or NWs.

Label-free detection methods have been used in genomic, proteomic, and cell growth sensors. For example, label-free cantilever-array sensors have been used to detect human RNA (Zhang, J., Lang, H. P., Bietsch, A., Huber, F., Certa, U., Guntherodt, H.-J., Hegner, M.* Gerber, Ch. (2006) Rapid and label-free nanomechanical detection of biomarker transcripts in human RNA Nature Nanotechnology, 1 ,214-220), interactions between transmembrane protein receptors and their ligands (Braun, T., Ghatkesar, M.K., Backmann, N. Grange, W., Boulanger, P., Letellier, L., Lang, H.P., Bietsch, A., Gerber, C., Hegner, M. (2009) Quantitative time-resolved measurement of membrane protein-ligand interactions using microcantilever array sensors Nature Nanotech. 4, 179-185), scFv fragments binding to antigens (Backmann, N., , Zahnd, Ch., Huber, F., Bietsch, A., Pluckthun, A., Lang, H.P., Guntherodt, H.J., Hegner, M.*, Gerber, Ch. (2005) A label-free immunosensor array using single-chain antibody fragments Proc. Natl. Acad. Sci. USA, 102 (41), 14587-14592), growth of bacteria in nutritive layers (Gfeller, K.Y, Nugaeva, N., Hegner, M.* (2005) Rapid biosensor for the detection of selective growth of Escherichia coli Appl. Env. Microbiol. 71 (5): 2626-2631), and detection of vital fungal spores of *Aspergillus niger* (Nugaeva, N., Gfeller, K., Backmann, N., Lang, H.P., Guntherodt, H.J., Hegner, M.(2007) An antibody-sensitized microfabricated cantilever for the growth detection of Aspergillus niger spores Microscopy and Microanalysis, 13,13-17).

The sensitivity of graphene is more sensitive than single walled carbon nano-tubes (SWCNTs) and nano-wires (NWs), and indeed first measurements on graphene devices have shown single molecule detection on a gated graphene device (Schedin, F.; Geim, A. K.; Morozov, S. V.; Hill, E. W.; Blake, P.; Katsnelson, M. I.; Novoselov, K. S. Nature Materials 2007, 6, 652-655). The versatility of graphene as a foundation for a sensor stems from its unique electronic structure, in that its ambipolarity property enables charge transport "chemical gating" of graphene to be monitored. It has also been demonstrated that graphene exhibits single molecule sensitivity and sensitivity towards the pH value and bio-molecules in electrolytes (Ohno, Y.; Maehashi, K.; Yamashiro, Y.; Matsumoto, K. Nano Letters 2009, 9, 3318-3322.). However, the issue of specific selectivity toward various analytes has so far been a major problem in the field. Nanomechanical label-free methods as described above are very sensitive but also mechanically fragile.

There is therefore a need to provide a nanocarbon- or graphene-based device suitable for use as a label-free biosensor and provided by a suitable method or process to overcome the above-mentioned problems.

### Summary of the Invention

According to the present invention there is provided, as set out in the appended claims, a sensor device comprising:
a first layer of graphene providing an interface; and
a second layer of at least one bio-compatible component, wherein the first layer is functionalised by anchoring of the at least one bio-compatible component of the second layer to the first layer.

One of the advantages of the present invention lies in utilising the enhanced sensitivity of graphene and combining that with analyte-specific selectivity. The sensors have an advantage in cost and stability when compared with current approaches. Graphene sensors are constructed as thin films which are chemically inert, flexible, bio-compatible, have low noise to electrical read outs and provide multiple parameters. In addition, the mass production of graphene sensors is simplified when compared to mass production of non graphene-based sensors from nano-materials.

A further advantage of the present invention is the provision of label-free, highly selective detection of analytes ranging from gas, liquids, and bio-molecules, and also analysing cell growth in in vitro culture conditions. The advantage provides devices which can test viability of cells (i.e. prokaryotes and eukaryotes) under certain growth conditions (sterility of solution, preservative tests, production control) in life and food science applications through detection on the graphene interfaces of the present invention. The devices have application in diagnostics, Q&S testing in industrial samples (quick test for contamination, for resistance), environmental control in healthcare facilities such as hospitals, and in the Biopharma industry such as food production controls.

In one embodiment the bio-compatible component of the second layer directly functionalises the graphene first layer.

In one embodiment a mediation layer is adapted to integrate between the first layer and second layer.

In one embodiment the mediation layer is functionalised by the anchoring of the at least one bio-compatible component of the second layer.

In one embodiment the mediation layer is a biocompatible polymer selected from the group comprising a dielectric polymer, a polymer adapted to store electrolytes, a polymer adapted to store a prokaryote and/or eukaryote cell growth medium, or an ion exchange membrane.

In one embodiment, the polymer may be suitable for polymer imprinting. In this specification, a polymer suitable for polymer imprinting is taken to mean a molecular imprinted polymer (MIP), which is a plastic polymer formed in the presence of a molecule that is extracted afterwards, leaving an imprint of the molecule or complementary cavities behind. The imprinted polymers demonstrate an affinity to for the original molecule. The process of polymer imprinting is well known to those skilled in the art.

In one embodiment the mediation layer may be a dielectric, such as, for example, an oxide layer selected from the group comprising aluminium oxide, silicon oxide, Hafnium oxide, Tantalum oxide, or nitrides, or mixtures thereof.

In one embodiment, the dielectric is deposited by atomic layer deposition.

In one embodiment, the dielectric is further functionalised with at least one biocompatible component.

In one embodiment the at least one bio-compatible component is selected from the group comprising single-stranded DNA, double-stranded DNA, ribonucleic acid (RNA), amino acids, proteins receptors, ligands, prokaryotic cells, or eukaryotic cells.

In one embodiment the first layer is sensitive to electrolyte and/or gas concentrations.

In one embodiment the mediation layer comprises a nutrition media for cells and said sensor comprises means for sensing changes in the composition of a liquid phase within the mediation layer.

In one embodiment the graphene layer is adapted to cooperate with an electrode.

In one embodiment the sensor comprises two or more electrodes to form a transistor junction such that the graphene layer forms a channel to provide a high sensitivity sensing area.

In one embodiment the bio-compatible component comprises a single molecule.

In one embodiment the sensor comprises a nano-carbon device.

In one embodiment there is provided a device for label-free detection comprising the sensor of the present invention.

In a further embodiment, there is provided a sensor device comprising:
a first layer of graphene providing an interface; and
a second layer of at least one component, wherein the first layer is functionalised by anchoring of the at least one component of the second layer to the first layer.

In another embodiment, there is provided a sensor device comprising:
a first layer of a carbon-based material providing an interface; and
a second layer of at least one bio-compatible component, wherein the first layer is functionalised by anchoring of the at least one bio-compatible component of the second layer to the first layer.

In a further embodiment, there is provided a sensor device comprising:
a first layer of a carbon-based material providing an interface; and
a second layer of at least one component, wherein the first layer is functionalised by anchoring of the at least one component of the second layer to the first layer.

In another embodiment there is provided a device for label-free detection comprising a sensor device comprising:
a first layer of graphene providing an interface; and
a second layer of at least one biocompatible component, wherein the first layer is functionalised by anchoring of the at least one biocompatible component of the second layer to the first layer.

In one embodiment, the graphene layer may have a thickness of between about 0.1 nm to about 100 nm, preferably between about 0.1 nm to about 50 nm, more preferably between about 0.1 nm to about 25 nm, between about 0.1 nm to about 15 nm, and ideally between about 0.1 nm to about 10 nm.

In another embodiment there is provided a method for producing a sensor comprising the steps of:
providing a first layer of graphene providing an interface; and
providing a second layer of at least one bio-compatible component, wherein the first layer is functionalised by anchoring of the at least one bio-compatible component of the second layer to the first layer.

### Brief Description of the Drawings

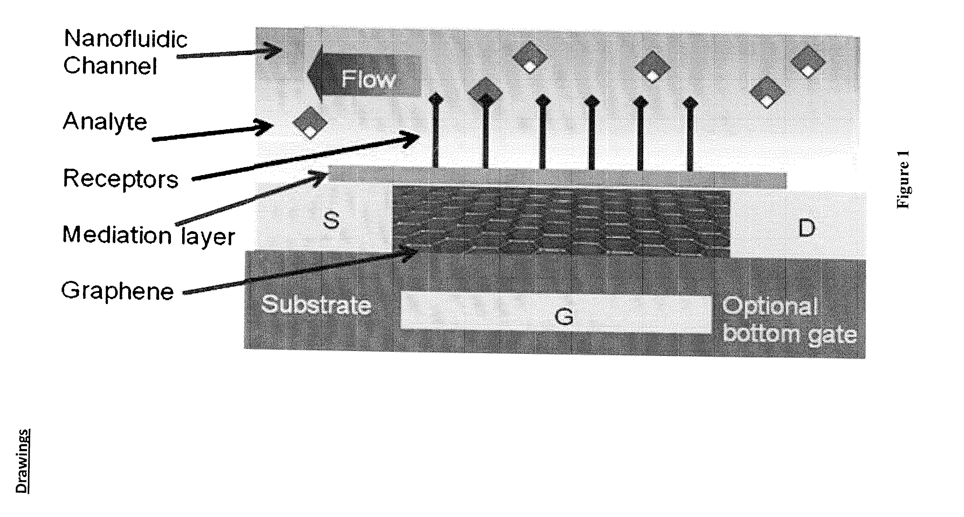

The invention will be more clearly understood from the following description of an embodiment thereof, given by way of example only, with reference to the accompanying drawings, in which:-
Figure 1 illustrates a biosensor of the present invention having, for example, receptor molecules for any one of chemical, genomic or proteomic analysis coupled directly or indirectly to a mediation layer deposited onto graphene by thin film deposition techniques such as atomic layer deposition (ALD) or ink-jet plotting;

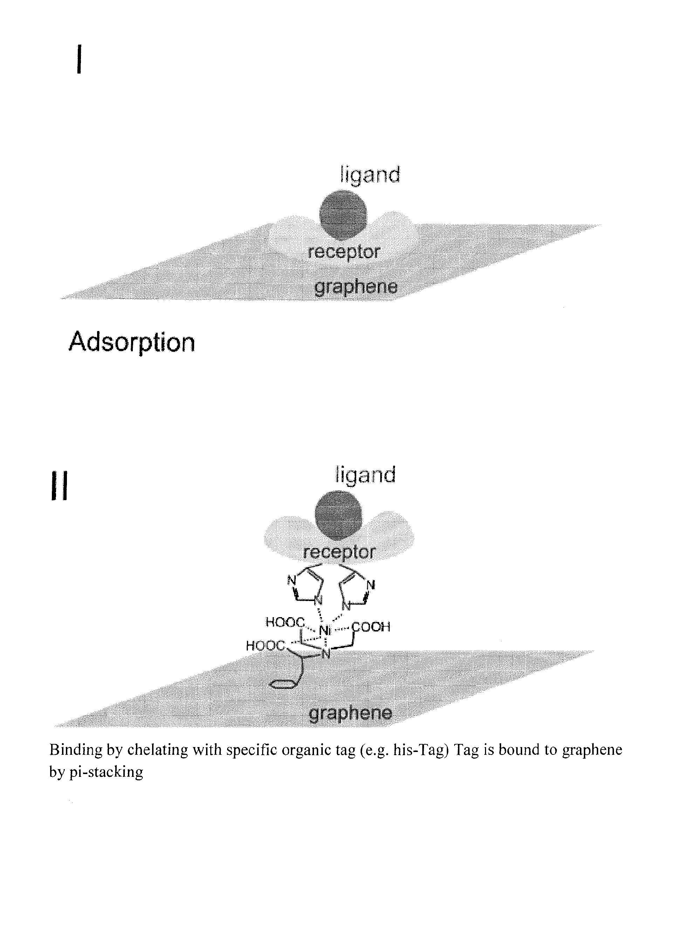

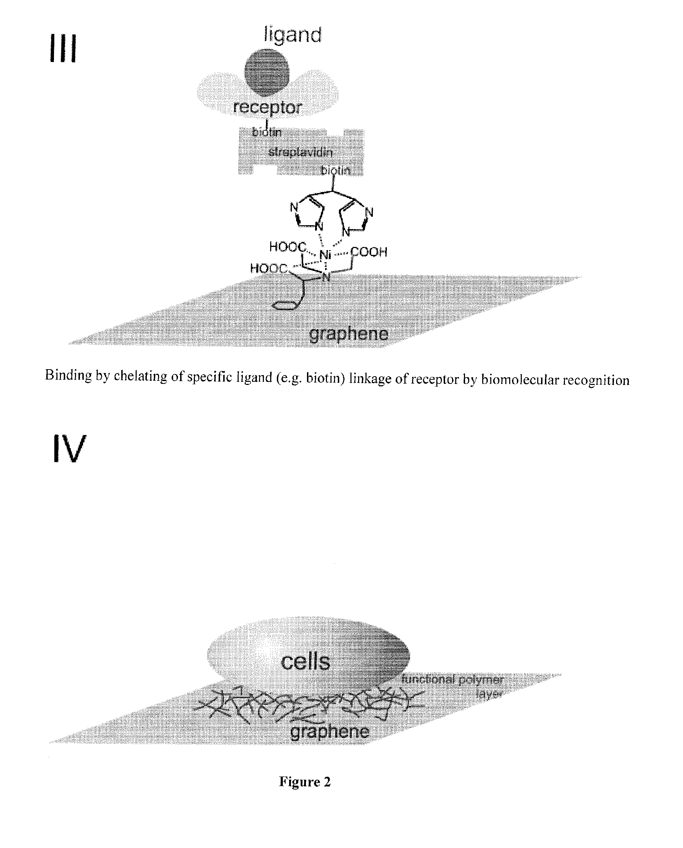

Figure 2 illustrates a schematic representation of various means to functionalize a graphene interface with a biological molecule/cell of interest: (I) direct adsorption of the bio-molecule of interest; (II) functionalizing a receptor molecule of interest with a chemical group and anchoring the receptor molecule to graphene chelation with a specific organic tag (for example, a HIS-tag) bound to graphene by pistacking via a nucleotide base; (III) a receptor of interest having multiple binding sites is modified with an affinity tag (for example, biotin-avidin), and anchored to a functional graphene via an intermediate receptor; and (IV) a thin mediation layer, for example a functional polymer layer, overlying the graphene may be filled with electrolytes which serves as a (cell-specific) medium reservoir for cell growth (prokaryotes and eukaryotes provides label-free detection enabled through electrical detection;

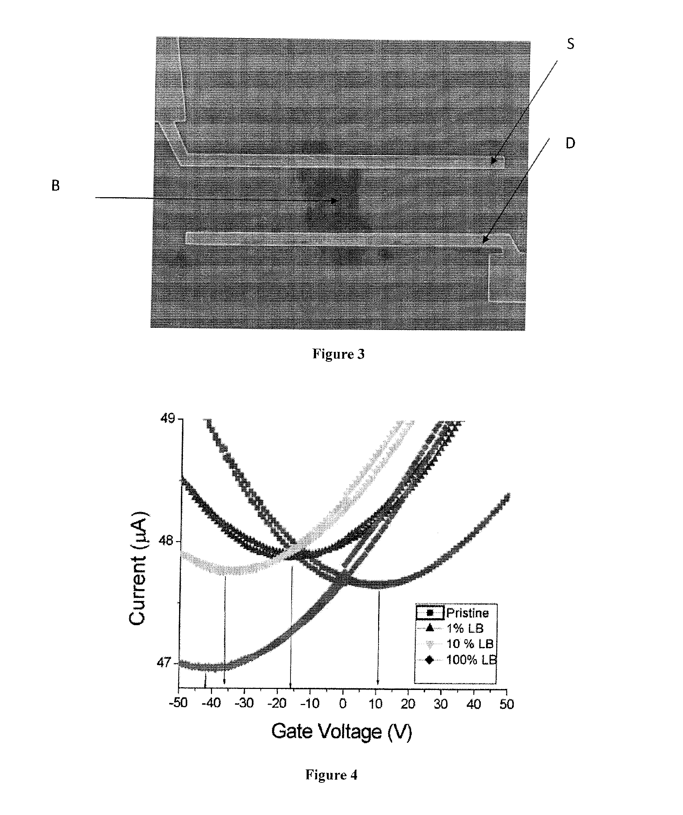

Figure 3 is an electronmicrograph of a device of the present invention; and
Figure 4 is graph of Current (µA) versus Gate Voltage (V) produced by the graphene sensor of Figure 3 (IV) where the active graphene area was contacted with gold electrodes by electro-beam lithography. The source-drain current I_{SD} through the electrodes with an applied voltage of U_{SD}=30 mV over a gate sweep of the substrate shows a parabolic shape typical for high quality multi-layered graphene. Its minimum is called the Dirac point and lies at Ug = + 10V.

### Detailed Description of the Drawings

Nano-carbon structures (NCs), and in particular graphene, exhibit unique mechanical and electrical properties. Many studies have shown the use of carbon nano-tube (CNT) networks as (flexible). Graphene has been shown to have superior sensitivity, being able to detect single molecules. Therefore it can potentially lead to ultra-low noise sensors due to the change of charge carried in 2-dimensional (2D) graphene flakes, ideally measured in a gated shift of the Dirac point.

Referring now to the figures, and initially to Figure 1, where Figure 1 illustrates a general embodiment of the present invention.

To produce a low-noise, label-free sensor of the present invention and utilising the superior sensitivity of graphene, receptor molecules of interest are introduced on or in the vicinity of a graphene sheet. Receptor molecules for chemicals, genomic or proteomic analysis will be coupled directly or indirectly to a mediation layer deposited onto graphene by thin film deposition techniques such as atomic-layer deposition (ALD) or ink-jet plotting. The mediation layer allows the introduction of specific receptors without destroying the ultra-sensitivity of graphene, in contrast to the indirect functionalisation methods.

A current flows from a sink (S) to a drain (D) across the graphene sheet and, optionally, measured by a bottom gate (G) embedded in a substrate. When fluid flows through a nano-fluidic channel in the opposite direction to the flow of current from S to D, and over the functionalised graphene sheet, any depletion in the concentration of the analyte of interest in the fluid following interaction with the receptor molecules adhered to the mediation layer, causes a change in the charge distribution in the nano-fluidic channel. The change in charge distribution is directly transferred to the graphene sheet underlying the mediation layer, which in turn modulates current transport through the device and a signal is generated. Similarly for nucleic acids, for example deoxyribonucleic acid (DNA), ribonucleic acid (RNA), a layer of single stranded (ss) or double stranded (ds) DNA are immobilised on the graphene sheet. The ssDNA are immobilised as a layer on the graphene sheet. When a sample containing ssDNA is passed over the sensor, complimentary ssDNA in the sample bind to the immobilised ssDNA on the graphene sheet. The hybridisation of ssDNA sequences changes the charge distribution at the surface of the graphene sheet. The change in charge distribution modulates the current transport through the device and is detected by the transfer characteristics through the graphene channel. This can be either seen in a change in resistance of the channel in two point configuration. In case of an additional gate, the change in the transfer characteristics (e.g. Dirac point shift) of the 3- terminal device (field effect transistor) can de detected (see Fig 4)

The sensor as illustrated in Figure 1 may be produced with a graphene sheet having a thickness of between about 0.1 nm to about 10 nm, the sensor synthesised by the following method:
A) Liquid or mechanical exfoliation of the graphene sheet, followed by pyrolysis of polymer layers (resigns, resist) by chemical vapour deposition (CVD) or catalysed CVD;
B) Deposition of the graphene sheet on a substrate. The substrate may be any one or more of the group comprising silicon oxide, aluminium oxide, or platinum;
C) Structuring the graphene sheet by photolithograpy or e-beam lithography followed by etching, laser cutting, and/or printing; and
D) Metal (for example, Ni, Pd, Pt, Au, and/or Ag) or carbon contact deposition.

As illustrated in Figure 1, the graphene sheet is overlaid with a mediation layer. The mediation layer is functionalised by site-specific immobilisation of receptors. The analyte or ligand present in a fluid or buffer flowing in the nanofluidic channel, in the opposite direction to the flow of charge, interacts directly with the receptor. The interaction of the receptor with the ligand directly transduces a shift in electrical conductivity of the underlying graphene sheet.

In Figure 2 there is illustrated a selection of methods to functionalize a graphene sheet interface with biocompatible buffer layers which enables anchoring of biological molecules of interest (e.g. receptors or ligands, nucleic acids, proteins (on a molecular scale), and whole cells (e.g. microorganisms and eukaryotic cells)).

The functionalisation of the graphene layers with bio-molecules can have four different routes:
(I) direct absorption of the bio-molecule to the graphene sheet,
(II) functionalizing the receptor molecule with a functional chemical group which induces complex formation (i.e. chelating), the anchoring to the graphene sheet then takes place by interaction with a counterpart of the complex group (e.g. fusion protein groups such as His-Tag linkage, GST-Tag linkage).
(III) A receptor with multiple binding sites is anchored to the functional graphene layer via a modifying reaction such as covalent linkage. An example of covalent linkage is a biotinylation reaction where the protein of interest is tagged with biotin which has an affinity for avidin and then anchored to an intermediate receptor.
(IV) A thin mediation layer can be a polymer layer filled with electrolytes which serves as a medium reservoir for cell growth (prokaryotes and eukaryotes), which can be selective for certain cells. Upon cell growth the media will change its composition (pH and/or bio-molecule concentration) which can be detected by the underlying graphene sheet due to changes in the electrical signals.

The above-described devices provide label-free detection enabled through electrical detection. The advantage over silicon nanowires or carbon nanotubes is provided by the fact that the large sheets of graphene can be synthesized and subsequently structured into individual active subunits for array read-out.

Turning to approach (IV) described for Figure 2 in more detail, the interface of the graphene sheet is covered with a buffer (polymer) layer which acts as a reservoir of nutritive molecules required for cell proliferation. Individual cells are settled on top of the buffer layer. During subsequent cell proliferation, the dividing cells use the nutritive molecules residing in the buffer layer. This leads to a shift in electrically active compounds nucleic acids, amino acids or sugars from the buffer layer into the dividing cells and subsequently leads to a shift in electrical conductivity in the underlying graphene. Such a device enables direct label-free detection of receptor-ligand interaction and the direct growth detection of cells residing on top of a buffer layer.

Figures 3 and 4 illustrate the device as described in Figure 2(IV) above. Figure 3 shows a graphene sheet (B) between two electrodes (S) and (D). Figure 4 is a graph of Current (µA) versus Gate Voltage (V) which demonstrates the device as described in Figure 2(IV) and shown in Figure 3. The graphene sheets (B) grown by chemical vapour deposition (CVD) were contacted with gold electrodes (S and D) with e-beam lithography. The source-drain current (I_{SD}) is passed through the electrodes with an applied voltage of U_{SD}=30 mV. Over a gate sweep of the substrate, Figure 3 shows a parabolic shape typical for high quality multi layered graphene (□ pristine). Its minimum point is called the Dirac point and lies at a gate voltage (V or Vg) of + 10V. After exposure to Luria Broth (LB) solution, which is typically used as media for bacteria growth, the Dirac point shifts to more negative voltages because of the interaction of the electrolytes in the LB with the graphene? The minima lay at - 17V, -34V and 43 V for a 1% (▲), 10% (▼), and 100% (◆) LB solution (nutritive solution), respectively. Thus, a concentration of LB solutions can be measured by a three terminal graphene device with high accuracy, since the shift in gate voltage can be measured in the mV range.

The sensors have a significant advantage in performance, reaction time, cost, and stability over current approaches.

In the specification, the term "layer" should be interpreted broadly as to comprise a sheet or platform or any surface that can support the sensor of the present invention and should be afforded the widest possible interpretation. Those terms, which can be interpreted broadly to be comprised in the term "layer", are also interchangeable with one another.

In the specification, it should be understood that the graphene layer may sit on any suitable type of substrate.

In the specification the terms "comprise, comprises, comprised and comprising" or any variation thereof and the terms include, includes, included and including" or any variation thereof are considered to be totally interchangeable and they should all be afforded the widest possible interpretation and vice versa.

The invention is not limited to the embodiments hereinbefore described but may be varied in both construction and detail.

## Claims

1. A sensor device comprising:
a first layer of graphene providing an interface; and
a second layer of at least one bio-compatible component, wherein the first layer is functionalised by anchoring of the at least one bio-compatible component of the second layer to the first layer.

2. The sensor of claim 1, wherein the bio-compatible component of the second layer directly functionalises the graphene first layer.

3. The sensor of claim 1, wherein a mediation layer is adapted to integrate between the first layer and second layer.

4. The sensor of claim 3 wherein the mediation layer is functionalised by the anchoring of the at least one bio-compatible component of the second layer.

5. The sensor of claim 3 or claim 4, where the mediation layer is a biocompatible polymer selected from the group comprising a dielectric polymer, a polymer adapted to store electrolytes, a polymer adapted to store a prokaryote and/or eukaryote cell growth medium, or an ion exchange membrane.

6. The sensor of claims 3 to 5, wherein the polymer is suitable for polymer imprinting.

7. The sensor of any of claims 3 to 6, wherein the mediation layer is a dielectric.

8. The sensor of claim 7, wherein the dielectric is an oxide selected from the group comprising aluminium oxide, silicon oxide, Hafnium oxide, Tantalum oxide or nitrides or mixtures thereof.

9. The sensor of claim 7 or claim 8, wherein the dielectric is deposited by atomic layer deposition.

10. The sensor of any of claims 7 to 9, wherein the dielectric is further functionalised with at least one bio-compatible component.

11. The sensor as claimed in any preceding claim the at least one bio-compatible component is selected from the group comprising single-stranded DNA, double-stranded DNA, ribonucleic acid (RNA), amino acids, proteins receptors, ligands, prokaryotic cells, or eukaryotic cells.

12. The sensor as claimed in any preceding claim wherein the first layer is sensitive to electrolyte and/or gas concentrations.

13. The sensor as claimed in any of claims 3 to 12 wherein the mediation layer comprises a nutrition media for cells and said sensor comprises means for sensing changes in the composition of a liquid phase within the mediation layer.

14. The sensor as claimed in any preceding claim wherein the graphene layer is adapted to co-operate with an electrode, wherein the sensor comprises two or more electrodes to form a transistor junction such that the graphene layer forms a channel to provide a high sensitivity sensing area.

15. A method for producing a sensor comprising the steps of:
providing a first layer of graphene providing an interface; and
providing a second layer of at least one bio-compatible component, wherein the first layer is functionalised by anchoring of the at least one bio-compatible component of the second layer to the first layer.
